# EUROPÄISCHE PATENTANMELDUNG

(11) **EP 1 454 999 A1**
(43) Veröffentlichungstag der Anmeldung: **08.09.2004**
(21) Anmeldenummer: 03026723.1
(22) Anmeldetag: 21.11.2003
(51) Int. Cl.: C23C 14/02, C23C 14/20

(54) **Werkstoff oder Bauteil mit einer Metallbeschichtung**

(30) Priorität: 03.12.2002 DE 10256484; 14.08.2003 DE 10337456
(71) Anmelder: HARTEC GESELLSCHAFT FUR HARTSTOFFE UND DUNNSCHICHTTECHNIK MBH & CO. KG, 72510 Stetten a.k.M. (DE)
(72) Erfinder: Ribeiro, Carlos, Dipl.-Ing., 72469 Messstetten (DE); Schäfer, Rüdiger, Dr., 79865 Grafenhausen (DE)
(74) Vertreter: Strych, Werner Maximilian Josef, Dr.

(57) **Zusammenfassung**

Die Erfindung betrifft einen Werkstoff oder ein Bauteil mit einer Metallbeschichtung aus einer oder mehreren aufeinander liegenden gleichen oder unterschiedlichen Metallschichten und dessen Verwendung für Maschinenkomponenten und -zubehör, Kraftfahrzeuge, Telekommunikationsgeräte, Haushaltsgeräte, Badarmaturen und -zubehör, Küchenarmaturen und -zubehör, medizinische Geräte, Schmuck- und Gebrauchsgegenstände.

## Beschreibung

### I. Anwendungsgebiet

Die Erfindung betrifft einen Werkstoff oder ein Bauteil mit einer Metallbeschichtung und dessen Verwendung für Maschinenkomponenten und - zubehör, Kraftfahrzeuge, Telekommunikationsgeräte, Haushaltsgeräte, Badarmaturen und -zubehör, Küchenarmaturen und -zubehör, medizinische Geräte, Schmuck- und Gebrauchsgegenstände.

### II. Technischer Hintergrund

Die Oberfläche eines Werkstoffes oder Bauteils bestimmt massgeblich dessen mechanische, thermische, chemische und optische Eigenschaften. Heutzutage werden Verfahren zur Behandlung von Oberflächen unter anderem dazu eingesetzt, um dem rohen Werkstoff oder Bauteil ein ansprechendes Erscheinungsbild zu verleihen, eine angenehme Haptik zu vermitteln und diesen/dieses wertvoller erscheinen zu lassen. In letzter Zeit geht der Trend insbesondere in Richtung metallischer Oberflächen mit verschiedenen optischen Effekten. Durch eine metallische Beschichtung von Werkstoffen oder Bauteilen lassen sich die Vorteile derselben (Kosten, Gewicht, Formgebung) mit den Eigenschaftsprofilen von metallischen Schichten kombinieren und die Eigenschaften des Werkstoffs oder Bauteils an ein gewünschtes Anforderungsprofil anpassen. Typische und industriell wichtige Anwendungen umfassen metallisierte Polymerwerkstoffe, wie leitfähige Schichten (z.B. Leiterplatten, Kondensatoren), Abschirmungen gegen elektromagnetische Strahlung (z.B. Computergehäuse, Mobiltelefone), dekorative Schichten (z.B. Badarmaturen), reflexierende Schichten (z.B. Scheinwerferreflektoren), verschleißbeständige Schichten (z.B. mechanische Übertragungsglieder), usw. Diese metallischen Oberflächen, welche beispielsweise eine hochglänzende Chromoptik oder das Aussehen von Aluminium aufweisen, werden herkömmlicherweise durch ein Galvanisierungs- oder PVD (physical vapor deposition)-Verfahren erzeugt.

Beim Galvanisieren wird üblicherweise eine nasschemische Bekeimung einer Oberfläche eines Werkstoffs oder Bauteils, beispielsweise aus einem Kunststoff, durchgeführt. Danach erfolgt eine stromlose chemische Grundmetallisierung. Die so erhaltende Schichtdicke beträgt etwa 40 bis 80 nm und wird im letzten Schritt galvanisch auf die jeweils benötigte Schichtdicke verstärkt. Durch Galvanisieren können hohe Schichtdicken mit einem sehr guten Korrosionsschutz erreicht werden. Die Nachteile des Galvanisierens sind jedoch die hohe Anzahl von Prozessschritten, die damit verbundene aufwändige Prozessstoffentsorgung sowie die Entstehung von Fehlstellen in der Form von Blasen auf den metallisierten Werkstoffen oder Bauteilen und die Versprödung der Oberfläche bzw. des Gesamtbauteils im Falle von dünnwandigen Bauteilen.

Die PVD-Verfahren werden als Konkurrenzverfahren zum Galvanisieren bei Werkstoffen oder Bauteilen eingesetzt, die keine feste Metallschicht als Oberflächenfinish benötigen (z.B. Leuchtenreflektoren, verchromte Folien, etc.). Die PVD-Verfahren werden im Allgemeinen für die Erzeugung von optischen und dekorativen Schichten eingesetzt, da hier Schichtdicken von < 5 µm notwendig sind. Die Vorteile der PVD-Verfahren gegenüber dem Galvanisierungsverfahren liegen zum einen darin, dass für die Metallisierung nur ein Prozessschritt notwendig ist. Zum anderen Entfallen die Kosten für die Entsorgung der Chemikalien. Überdies erhält man metallisierte Werkstoffe oder Bauteile mit sehr homogenen Schichten.

Bei den PVD-Verfahren unterscheidet man grundsätzlich zwischen zwei verschiedenen Verfahren. Einerseits gibt es die kostengünstigere Variante des Bedampfens, bei der durch die Zufuhr thermischer Energie bei Niedrigtemperatur schmelzende Metalle verdampft und so auf die Oberflächen des Werkstoffs oder des Bauteils aufgebracht werden. Dieses Verfahren wird beispielsweise bei der Bedampfung von Aluminium oder Kupfer verwendet. Dabei werden jedoch nur Aluminium- bzw. Kupferschichten mit einer ungenügenden Haftfestigkeit und einer geringen chemischen Beständigkeit erhalten. Dies kann dazu führen, dass die Metallbeschichtung abblättert und/oder sich Feuchtigkeit einlagert. Zudem können damit keine unterschiedlichen Farbtöne erzeugt werden. Andererseits wird das Sputtern von Substratmaterial, wie beispielsweise Edelstahl, mit Hilfe eines ionisierten Prozessgases eingesetzt. Dabei wird ein Prozessgas (meist Argon) ionisiert und mittels Magnetfeldunterstützung auf das abzuscheidende Material (Target) beschleunigt (Magnetronsputtern). Durch Impulsübertragung der ionisierten Gasatome werden im Vakuum Atome und Atomcluster aus dem Target herausgeschlagen und lagern sich auf den Substraten ab. Das Sputtern von Edelstahl alleine weist ebenfalls den Nachteil auf, dass die Haftfestigkeit der Edelstahlschicht ungenügend ist und die Erzeugung von Farbtönen nicht möglich ist.

Mit Hilfe der oben beschriebenen Verfahren lassen sich jedoch nicht alle Materialien metallisieren. Häufig müssen die Oberflächen der Werkstoffe oder Bauteile vor der Metallisierung vorbehandelt werden, da sie sonst nicht lackiert, verklebt, beschäumt, metallisiert oder auf eine andere Art und Weise beschichtet werden können. Dies ist darauf zurückzuführen, dass die Werkstoffe oder Bauteile, insbesondere solche aus Polymeren, meist hydrophob sind, d.h. niedrige Oberflächenenergien aufweisen. Deshalb werden einige Werkstoffe oder Bauteile zunächst mittels spezieller Verfahren zur Behandlung von Oberflächen, wie beispielsweise nasschemische Oberflächenvorbehandlungsverfahren, wie Beizen, und physikalische Oberflächenvorbehandlungsverfahren, wie Beflammung (Pyrolyse), Fluorierung, Coronabehandlung und Plasmaverfahren, vorbehandelt bzw. aktiviert. Durch den Vorgang der Aktivierung wird die Polarität bzw. die Oberflächenenergie des Werkstoffes oder Bauteils erhöht, wodurch ein verbessertes Haftvermögen bzw. eine verbesserte Benetzbarkeit erzielt wird.

Bei der Aktivierung von Werkstoffen oder Bauteilen spielt die Plasmaaktivierung eine immer größere Rolle, da dadurch ein sehr gutes Haftvermögen erreicht werden kann und auch solche Polymere aktiviert werden können, die beispielsweise nasschemisch nicht oder nicht wirtschaftlich zugänglich sind. Bei der Plasmaaktivierung wird ein Gas oder ein Gasgemisch (z.B. Argon, Sauerstoff, Stickstoff, Ammoniak etc.) einer elektrischen Gasentladung im Vakuum unterzogen. Dabei werden Elektronen, Ionen, Radikale und Neutralteilchen erzeugt, die auf die Oberfläche des Werkstoffs oder Bauteils prallen. Dadurch können Kontaminationen entfernt und die Oberfläche aufgeraut und chemisch modifiziert werden. Die erhaltenen Modifikationen sind dabei abhängig vom verwendeten Gas. Verwendet man beispielsweise Sauerstoff, ist es möglich, Werkstoffe oder Bauteile so zu modifizieren, dass Hydroxyl-, Carboxyl- oder Peroxidgruppen an der Oberfläche entstehen. Verwendet man dagegen Stickstoff oder Ammoniak, so führt das zu Amin- oder Imin-Gruppen, welche für bestimmte Anwendungen ebenfalls interessant sein können. Durch die Erzeugung von polaren hydrophilen Gruppen erhöht sich die Energie und somit die Benetzbarkeit der Oberfläche des behandelten Werkstoffs oder Bauteils.

Die Metallisierung von Werkstoffen oder Bauteilen aus Kunststoffen, wie Silikon oder TPU, gestaltet sich jedoch häufig schwierig, da diese teilweise gar nicht oder nur aufwendig vorbehandelt bzw. aktiviert werden können. Im Stand der Technik sind insbesondere keine Verfahren zur Direktmetallisierung von Werkstoffen oder Bauteilen aus bestimmten Materialien, insbesondere aus Polymeren, wie beispielsweise Silikon oder TPU, welche aufgrund ihrer Eigenschaften vielseitig anwendbar sind, bekannt. Vielmehr erfordert das Metallisieren die Verwendung eines Haftvermittlers, wie beispielsweise eines Lacksystems. Des Weiteren ist die Reproduzierbarkeit und Kontrollierbarkeit der Plasmaaktivierung durch die im Stand der Technik bekannten Verfahren unbefriedigend und die plasmaaktivierte Oberfläche bleibt nur für eine begrenzte und sehr kurze Zeitdauer aktiv. Um die Dauer der Aktivierung zu verlängern, muss der Werkstoff oder das Bauteil beispielsweise in Wasser getaucht und anschließend wieder getrocknet werden, wodurch sich sowohl unerwünschte Effekte bei der Lackierung ergeben als auch zusätzliche Kosten verursacht werden. Ferner ist die Erzeugung von gezielten optischen Effekten, wie beispielsweise verschiedenen Farbtönen oder Mattheit/Glanz, durch die im Stand der Technik bekannten Metallisierungsverfahren schwierig. Häufig weisen die vorbekannten Metallbeschichtungen der so beschichteten Werkstoffe oder Bauteile zudem lediglich eine geringe Haftfestigkeit sowie eine geringe chemische Beständigkeit auf. Die Aufbringung von Metallbeschichtungen aus mehreren aufeinander liegenden gleichen oder unterschiedlichen Metallschichten ist bislang ebenfalls nicht beschrieben.

### III. Darstellung der Erfindung

### a) Technische Aufgabe

Der Erfindung liegt daher die Aufgabe zugrunde, einen Werkstoff oder ein Bauteil mit einer Metallbeschichtung aus ein oder mehreren aufeinander liegenden gleichen oder unterschiedlichen Metallschichten zur Erzielung von optischen Effekten bereitzustellen, bei dem die Metallbeschichtung direkt, d.h. ohne Verwendung eines Haftvermittlers, auf die Oberfläche aufgebracht ist und welche eine ausgezeichnete Haftfestigkeit sowie eine ausgezeichnete chemische Beständigkeit aufweist.

### b) Lösung der Aufgabe

Diese Aufgabe wird erfindungsgemäss durch die Merkmale der Patentansprüche 1, 26 und 39 gelöst. Vorteilhafte Ausführungsformen der vorliegenden Erfindung sind in den abhängigen Ansprüchen beschrieben.

Der erfindungsgemäße Werkstoff oder das erfindungsgemäße Bauteil mit einer Metallbeschichtung zeichnet sich insbesondere dadurch aus, dass die Metallbeschichtung durch eine Direktmetallisierung auf die Oberfläche des Werkstoffs oder Bauteils aufgebracht ist und weist gegenüber den im Stand der Technik bekannten metallisierten Werkstoffen oder Bauteile verbesserte Eigenschaften bezüglich der Haftfestigkeit und der chemischen Beständigkeit auf, wodurch ein breites Anwendungsgebiet eröffnet wird.

Ein weiterer Vorteil der erfindungsgemäßen, metallbeschichteten Werkstoffe oder Bauteile ist, dass diese in Abhängigkeit von der chemischen Zusammensetzung und dem spezifischen Aufbau der Metallbeschichtung, wie beispielsweise eine oder mehrere aufeinander liegende gleiche oder unterschiedliche Metallschichten, unterschiedliche Erscheinungsbilder aufweisen können. So kann die Metalloberfläche des erfindungsgemäßen Werkstoffes oder Bauteils glänzend oder matt sein sowie verschiedene Farbtöne aufweisen. Ferner kann eine gewünschte Optik, wie beispielsweise Oberflächenglanz bzw. -struktur, zusätzlich durch Nachlackieren mit einem Klar- oder Strukturlack eingestellt werden. Des Weiteren kann eine gewünschte farbige Metalloptik, welche allein durch Metallbeschichtung nicht erzielt werden kann, auch durch Nachlackieren mit einem gefärbten Klar- oder Strukturlack erzeugt werden.

Der erfindungsgemässe Werkstoff oder das erfindungsgemässe Bauteil mit einer Metallbeschichtung ist dadurch gekennzeichnet, dass die Metallbeschichtung durch eine Direktmetallisierung auf die Oberfläche des Werkstoffes oder Bauteils aufgebracht ist und die Metallbeschichtung aus einer oder mehreren aufeinander liegenden gleichen oder unterschiedlichen Metallschichten besteht.

Der erfindungsgemäße Werkstoff oder das erfindungsgemässe Bauteil ist hinsichtlich seiner chemischen und physikalischen Eigenschaften auf keine Art und Weise eingeschränkt und besteht beispielsweise aus einem Material ausgewählt aus der Gruppe bestehend aus metallischen Materialien, Glas, Keramik, Polymeren, Holz und Gummi. Vorzugsweise ist der Werkstoff oder das Bauteil aus einem Polymer, wobei das Polymer gegebenenfalls mit einem Füllstoff, wie Glasfasern und/oder Mineralstoffen, wie beispielsweise Korund und Aluminiumoxid und/oder Glaskugeln gefüllt sein kann. Bevorzugte Polymere sind Kunststoffe, wie Polycarbonat (PC), Acrylnitril-Butadien-Styrol (ABS), (PC+ABS)-Blends, Acrylnitril-Styrol (ASA, AES, ACS), Polyamid (PA), Polyarylamid (PAA), Polyethylen (PE), Polystyrol (PS), thermoplastisches Polyurethan (TPU), thermoplastische Elastomere (TPE, TPE-E, TEEE), Polyaryletherketone (PAEK, PEK, PEEK), Polybutylenterephthalat (PBT), Polyethylenterephthalat (PET), Styrol-Acrylnitril (SAN), Liquid-Crystal-Polymere (LCP), Polyimide (PI, PMI, PEI, PAI), Celluloseester (CA, CP, CAB), Polyvinylchlorid (PVC), Polymethylmethacrylat (PMMA), Polyoxymethylen (POM), Polypropylen (PP), Polyphenylenether (PPE), Polyarylsulfone (PSU, PES), Polyphenylensulfid (PPS), Polyphtalamid (PPA), Duroplaste (PF, MF, MP, UF, UP), Epoxidharze (EP), Silikone (HTV, LSR) und Sonderharze aus Silikon, Diallylphthalat, Vinylester oder Polyurethanen (PUR). Besonders bevorzugt sind Silikon oder thermoplastisches Polyurethan (TPU). Besonders bevorzugte thermoplastische Polyurethane sind flexible thermoplastische Polyurethane. Besonders bevorzugte Silikone sind flexible Silikone, d.h. Feststoffsilikon (HTV) bzw. Flüssigsilikon (LSR), wie z.B. Dimethylsiloxan.

Der erfindungsgemässe Werkstoff oder das erfindungsgemässe Bauteil umfasst eine Metallbeschichtung aus einer oder mehreren aufeinander liegenden gleichen oder unterschiedlichen Metallschichten. Das Aufbringen von einzelnen Metallschichten mit einer definierten chemischen Zusammensetzung der aus einer oder mehreren aufeinander liegenden gleichen oder unterschiedlichen Metallschichten bestehenden Metallbeschichtung mittels Direktmetallisierung eröffnet die Möglichkeit, ein Schichtgefüge zu erzeugen, das ganz bestimmte Eigenschaften aufweist. So können physikalische Eigenschaften, wie Zähigkeit, Abriebbeständigkeit, Spannung etc. sowie optische Eigenschaften, wie der Farbton oder das Maß des Glänzens beziehungsweise der Mattheit, je nach Erfordernis eingestellt werden. Die Oberfläche eines Werkstoffs oder Bauteils aus Silikon oder TPU kann beispielsweise zunächst verchromt werden, wodurch eine hohe Haftfestigkeit erreicht wird, gefolgt von einer Schicht aus ZrN, wodurch eine sehr harte messing-gelbe Schicht erzeugt wird.

Die Metallbeschichtung des erfindungsgemäßen Werkstoffs oder Bauteils weist in Abhängigkeit von der Lichtdurchlässigkeit eine unterschiedliche Gesamtschichtdicke auf. Im Falle einer teillichtdurchlässigen Metallbeschichtung beträgt die Gesamtschichtdicke der Metallbeschichtung 20 bis 200 nm, vorzugsweise 40 bis 120 nm. Die Anzahl der aufeinander liegenden Metallschichten der teillichtdurchlässigen Metallbeschichtung liegt vorzugsweise im Bereich von 1 bis 50, besonders bevorzugt im Bereich von 3 bis 25. Im Falle einer nicht lichtdurchlässigen Metallbeschichtung beträgt die Gesamtschichtdicke der Metallbeschichtung 100 bis 5000 nm, vorzugsweise 200 bis 2000 nm. Die Anzahl der aufeinander liegenden Metallschichten der lichtdurchlässigen Metallbeschichtung liegt vorzugsweise im Bereich von 1 bis 500, besonders bevorzugt im Bereich von 8 bis 180. Vorzugsweise beträgt die Dicke einer einzelnen teillichtdurchlässigen oder nicht lichtdurchlässigen Metallschicht der Metallbeschichtung 3 bis 120 nm. Die teillichtdurchlässigen Metallbeschichtungen des erfindungsgemäßen Werkstoffs oder Bauteils weisen eine Transmission von sichtbarem Licht im Bereich von 0,5% bis 60%, vorzugsweise im Bereich von 3% bis 30%, auf.

Die einzelnen gleichen oder unterschiedlichen Metallschichten der Metallbeschichtung bestehen aus wenigstens einem Metall ausgewählt aus den Elementen der Gruppen 4 bis 14 des Periodensystems, Legierungen davon und/oder Edelstahl. Vorzugsweise bestehen die Metallschichten aus wenigstens einem Metall ausgewählt aus den Elementen der Gruppen 4 bis 6 des Periodensystems, Al, Rh, und Si, Legierungen davon und/oder Edelstahl. Besonders bevorzugt sind Ti, Zr, Cr, Mo, Rh, Al, Si, Legierungen davon/oder Edelstahl. Bevorzugte Legierungen sind beispielsweise CrAl, RhAl, MoAl und CrZr.

Gegebenenfalls können eine oder mehrere der aufeinander liegenden gleichen oder unterschiedlichen Metallschichten der Metallbeschichtung des erfindungsgemässen Werkstoffs oder Bauteils metallkeramische Schichten, wie ZrN oder TiCrCN, sein. Diese verleihen der Metallbeschichtung spezielle Eigenschaften, wie Härte, Farbe und Zähigkeit.

Die Direktmetallisierung des erfindungsgemässen Werkstoffs oder Bauteils erfolgt schrittweise, d.h. jede einzelne Metallschicht der aus einer oder mehreren aufeinander liegenden gleichen oder unterschiedlichen Metallschichten bestehenden Metallbeschichtung wird nacheinander schichtweise abgeschieden. Dabei wird jeweils ein Metall, eine Metalllegierung oder eine metallkeramische Zusammensetzung von definierter Zusammensetzung schichtartig nacheinander abgeschieden. Der Gehalt eines bestimmten Elementes innerhalb einer einzelnen Metallschicht der Metallbeschichtung kann dabei von der auf der Oberfläche des Werkstoffs oder des Bauteils aufliegenden ersten Metallschicht bis zur letzten Metallschicht variieren, d.h. insbesondere auch kontinuierlich zu- oder abnehmen. Ferner kann auch die Dicke der einzelnen Metallschichten der Metallbeschichtung von der auf der Oberfläche des Werkstoffs oder des Bauteils aufliegenden ersten Metallschicht bis zur letzten Metallschicht variieren, d.h. insbesondere auch kontinuierlich zu- oder abnehmen. Die Abfolge der einzelnen Metallschichten sowie deren chemischen Zusammensetzungen richten sich nach dem jeweiligen Verwendungszweck des erfindungsgemässen Werkstoffs oder Bauteils.

In einer bevorzugten Ausführungsform wird, da reine Metallbeschichtungen aus Aluminium häufig nicht korrosionsbeständig sind und zum Abblättern und/oder Anlagern von Feuchtigkeit neigen und deshalb vor der Metallisierung beispielsweise mit einem haftvermittelnden Lack überzogen werden müssen, bei einem erfindungsgemäßen Schichtaufbau zunächst eine korrosionsbeständige Metallschicht (Haftschicht) aufgebracht. Diese Haftschicht besteht aus einem korrosionsbeständigen Werkstoff wie beispielsweise Mo, Cr oder Edelstahl oder eine Al-Legierung wie MoAl mit einem Al-Gehalt von nicht mehr als 40 bis 60% Al.

In einer weiteren bevorzugten Ausführungsform besteht die Metallbeschichtung des erfindungsgemässen Werkstoffs oder Bauteils aus einer oder mehreren aufeinander liegenden unterschiedlichen Metallschichten, die abwechslungsweise aus Aluminium (Al) bzw. einer Legierung davon und Molybdän (Mo) oder einer Legierungen davon bestehen. In einer weiteren bevorzugten Ausführungsform besteht die Metallbeschichtung aus einer oder mehreren aufeinander liegenden unterschiedlichen Metallschichten, die abwechslungsweise aus Aluminium (Al) bzw. einer Legierung davon und Chrom (Cr) bzw. einer Legierung davon bestehen. In einer weiteren bevorzugten Ausführungsform besteht die Metallbeschichtung aus einer oder mehreren aufeinander liegenden unterschiedlichen Metallschichten, die abwechslungsweise aus Aluminium (Al) bzw. einer Legierung davon und Rhodium (Rh) bzw. einer Legierung davon bestehen. In einer weiteren bevorzugten Ausführungsform besteht die Metallbeschichtung aus einer oder mehreren aufeinander liegenden unterschiedlichen Metallschichten, die abwechslungsweise aus Aluminium (Al) bzw. einer Legierung davon und Silizium (Si) bzw. einer Legierung davon bestehen. In einer weiteren bevorzugten Ausführungsform besteht die Metallbeschichtung aus einer oder mehreren aufeinander liegenden unterschiedlichen Metallschichten, die abwechslungsweise aus Aluminium (Al) bzw. einer Legierung davon und einer rostfreien Edelstahllegierung bestehen. Besonders bevorzugte Ausführungsformen der obigen Ausführungsformen umfassen Metallbeschichtungen aus einer oder mehreren aufeinander liegenden unterschiedlichen Metallschichten, die abwechslungsweise aus Al und Mo, Al und Cr, Al und Rh, Al und Si, und Al und rostfreiem Edelstahl bestehen.

Eine bevorzugte Metallbeschichtung des erfindungsgemässen Bauteils oder Werkstoffs ist wie folgt aufgebaut:

| | |
|---|---|
| Anzahl der einzelnen Metallschichten: | ca. 25 |
| Metalle für die Metallbeschichtung: | Chrom und Aluminium |
| Haftschicht: | Chrom, ca. 60 nm |
| Metallbeschichtungsaufbau (abwechselnd): | Aluminium 3 bis 15 nm (zunehmend) Chrom 20 bis 5 nm (abnehmend) |
| Deckschicht: | Chrom, ca. 20 nm |
| Gesamtschichtdicke: | ca. 330 nm |

Mit Hilfe des oben beschriebenen Schichtaufbaus der Metallbeschichtung des erfindungsgemässen Bauteil oder Werkstoffs können neben der ausgezeichneten Haftfestigkeit und chemischen Beständigkeit in Abhängigkeit von der chemischen Zusammensetzung und der Art und Abfolge der einzelnen Metallschichten insbesondere verschiedene optische Effekte erreicht werden. Beispielsweise kann durch Chrom ein Blaustich, mit Molybdän ein Gelb- bis Rotstich und mit Aluminium ein Weißstich erzielt werden. Durch Kombination dieser Elemente untereinander oder mit einem anderen Element einer Metallschicht der Metallbeschichtung des erfindungsgemäßen Bauteils oder Werkstoffs können andere Farbtöne und/oder Mischfarbtöne erzeugt werden. Des Weiteren eröffnet die aus einzelnen Metallschichten bestehende Metallbeschichtung des erfindungsgemäßen Bauteils oder Werkstoffs aufgrund ihrer spezifischen chemischen Zusammensetzung die Möglichkeit zur selektiven, wellenlängenabhängigen Transmission, wodurch unterschiedliche Farbeffekte erzeugt werden können.

In einer weiteren bevorzugten Ausführungsform der vorliegenden Erfindung ist die Metallbeschichtung durch ein PVD-Verfahren direkt auf die Oberfläche des Werkstoffs oder Bauteils aufgebracht. Dabei ist die aus einer oder mehreren aufeinander liegenden gleichen oder unterschiedlichen Metallschichten bestehende Metallbeschichtung vorzugsweise durch Bedampfen, Sputtern und Arc-Verdampfen aufgebracht. Besonders bevorzugt ist die Metallbeschichtung durch Sputtern aufgebracht.

Beim Sputtern wird ein Prozessgas, wie ein Edelgas, vorzugsweise Argon (Ar), ionisiert und mittels Magnetfeldunterstützung auf das abzuscheidende Target beschleunigt. Im vorliegenden Fall kann beispielsweise eine wie in der Deutschen Patentanmeldung DE 36 13 018 A1 offenbarte Magnetron-Zerstäubungskathode verwendet werden, die mit einer spezifischen Leistung von 1 bis 30 W/cm², vorzugsweise 5 bis 20 W/cm² und einer Spannung von 200 bis 1000 V, vorzugsweise 300 bis 500 V, betrieben wird. Der Druck in der Prozesskammer beträgt 10⁻⁴ bis 10⁻¹ mbar, vorzugsweise 10⁻³ bis 10⁻² mbar.

Als Target-Materialien können je nach dem geforderten metallischen oder metallkeramischen Erscheinungsbild des erfindungsgemässen Werkstoffs oder Bauteils alle dafür geeigneten Metalle und Legierungen verwendet werden. Geeignete Target-Materialien umfassen Elemente der Gruppen 4 bis 14 des Periodensystems, Legierungen davon und/oder Edelstahl. Vorzugsweise umfassen die Target-Materialien Elemente der Gruppen 4 bis 6 des Periodensystems, Al, Rh, und Si, Legierungen davon und/oder Edelstahl. Besonders bevorzugt sind die Target-Materialien Ti, Zr, Cr, Mo, Rh, Al, Si, Legierungen davon/oder Edelstahl. Bevorzugte Legierungen sind beispielsweise CrAl, RhAl, MoAl, CrZr, CrRh, CrMo, MoRh und MoZr.

An den erfindungsgemässen Werkstoff oder das erfindungsgemässe Bauteile wird üblicherweise eine negative Spannung von -10 bis -250 V, vorzugsweise -25 bis -80 V angelegt. Die Oberfläche des Werkstoffes oder des Bauteils wird bei einer Temperatur von 20 °C bis 100 °C, insbesondere 30 °C bis 60 °C, bestäubt. Die Beschichtungsdauer beträgt für die Erzeugung einer teillichtdurchlässigen Metallbeschichtung 30 Sek. bis 300 Sek., vorzugsweise 60 bis 180 Sek., und für die Erzeugung einer nicht lichtdurchlässigen Metallbeschichtung 30 Sek. bis 60 Min., vorzugsweise 3 bis 20 Min.

In einer weiteren bevorzugten Ausführungsform kann die Metallbeschichtung eine oder mehrere metallkeramische Schichten umfassen. Dies ist insbesondere möglich, wenn das Sputtern in Gegenwart eines Reaktivgases, umfassend ein Stickstoff, Kohlenstoff, Silicium, Bor und/oder Sauerstoff enthaltendes Gas, vorzugsweise N₂, CO₂, C₂H₂, C₂H₄, C₂H₆, durchgeführt wird. Die metallkeramischen Beschichtungen, wie beispielsweise ZrN oder TiCrCN, verleihen der Metallbeschichtung spezielle Eigenschaften, wie Härte, Abriebbeständigkeit, Farbe und Zähigkeit.

Die mittels eines PVD-Verfahrens beschichteten Werkstoffe oder Bauteile, beispielsweise aus einem Polymer, können mit einem hochtransparenten Lack ohne merkliche Farbänderung der Metallbeschichtung nachlackiert oder mit einem Plasmapolymer mittels eines PECVD-Verfahrens (PECVD, plasma enhanced chemical vapor deposition) überzogen werden. Diese Deckschichten übernehmen eine Schutzfunktion und sind beispielsweise kratzresistent, antikorrosiv, antihaftend und schmutzabweisend. Es ist jedoch auch möglich diese Werkstoffe oder Bauteile mit einem gefärbten oder nicht gefärbten Strukturlack zur Einstellung einer gewünschten Optik nachzulackieren. Dadurch können Effekte wie beispielsweise Mattiertheit, Milchigkeit, Metallic-Effekt, Aussehen von eloxiertem Aluminium etc. und gegebenenfalls bestimmte Farbtöne erzielt werden. Ein weiterer Effekt entsteht bei der Verwendung von gefärbten oder nicht gefärbten Klarlacks für die Nachbeschichtung. Die Metallbeschichtungen des erfindungsgemäßen Bauteils oder Werkstoffs aus abwechselnd angeordneten Metallschichten aus beispielsweise Cr und Ag, Mo und Al sowie Rh und Al weisen nämlich eine sehr hohe Lichtreflexion und dementsprechend hochglänzende Oberflächen auf. Dieser Hochglanz-Effekt der Oberfläche der Metallbeschichtung, z.T. auch von hierfür speziell geeigneten Strukturoberflächen (z.B. Schliffbild), kann durch Nachlackieren mit einem Hochglanz-Klarlack noch verstärkt werden. Soll eine gewünschte farbige Metalloptik erreicht werden, die alleine aufgrund der Metallbeschichtung nicht erzielt werden kann, wie beispielsweise ein "Smaragd-" bzw. "Rubin"-Effekt, wird dem Klarlack eine entsprechende Einfärbung in grün bzw. rot beigegeben. In ähnlicher Weise kann auch ein "Palladium-" bzw. "Ruthenium"-Effekt erzielt werden, wobei dem Lack in diesen Fällen eine Einfärbung in weiss-gelb bzw. grau-weiss zugegeben wird.

Gewisse Bauteile oder Werkstoffe, wie beispielsweise mittels Spritzgießen hergestellte Bauteile, sind hinsichtlich ihrer Oberflächengüte unbefriedigend. Solche Bauteile oder Werkstoffe werden deshalb vor der Metallisierung mit einem geeigneten Hochglanz- oder Strukturlack vorlackiert. Man beachte, dass diese Lackierung nicht dazu dient, die Haftfestigkeit zu erhöhen, wie dies bei den als Haftvermittlern eingesetzten Lacken der Fall ist, sondern vielmehr dazu dient, die Oberflächengüte zu verbessern.

In einer weiteren bevorzugten Ausführungsform der Erfindung ist die Oberfläche des Werkstoffs oder Bauteils, beispielsweise aus bestimmten Polymeren, wie Silikon oder thermoplastischem Polyurethan (TPU), vor der Direktmetallisierung mittels eines Plasmaverfahrens gegebenenfalls aktiviert worden, wodurch die Haftfestigkeit erhöht wird. Die beiden Prozessschritte Aktivierung und Direktmetallisierung können dabei in einer einzigen Anlage hintereinander durchgeführt werden. Eine solche Aktivierung ist insbesondere bei Polymeren, wie beispielsweise Silikon, TPU (thermoplastisches Polyurethan), PMMA (Polymethylmethacrylat), POM (Polyoxymethylen), PP (Polypropylen), PE (Polyethylen), TPE (thermoplastisches Elastomer), PA (Polyamid) und Polybutylenterephthalat (PBT) bevorzugt.

Das erfindungsgemäße Plasmaverfahren zur Aktivierung der Oberfläche des Werkstoffs oder Bauteils umfasst die Schritte des Einbringens des Werkstoffs oder Bauteils in eine Prozesskammer, des Ausgasens desselben, des kontinuierlichen Abpumpens der Ausgasungen mittels Vakuumpumpen und des Aktivierens der Oberfläche des Werkstoffs oder Bauteils mit einem durch eine elektrische Gasentladung im Vakuum erzeugten Plasma, wobei die Energie und die Einwirkdauer des Plasmas auf die Oberfläche des Werkstoffes oder Bauteils so gewählt ist, dass die oberflächennahen Moleküle signifikant modifiziert werden und der Werkstoff oder das Bauteil direkt mit einem PVD-Verfahren metallisiert werden kann.

Das Ausgasen erfolgt für 3 bis 60 Min., vorzugsweise 10 bis 30 Min., bei einer Temperatur von 20 °C bis 100 °C, vorzugsweise 30 °C bis 60 °C, und einem Druck von 10⁻⁵ bis 10⁻¹ mbar, vorzugsweise 10⁻⁴ bis 10⁻² mbar, wobei die Ausgasungen mittels Vakuumpumpen kontinuierlich aus der Prozesskammer abgepumpt werden.

Die Oberfläche des Werkstoffs oder Bauteils wird dann zur Aktivierung durch Ionen und/oder Elektronen, die durch eine elektrische Gasentladung im Vakuum erzeugt werden, beschossen. Der Druck in der Prozesskammer liegt im Bereich zwischen 10⁻⁴ und 10⁻¹ mbar, vorzugsweise im Bereich zwischen 10⁻³ und 10⁻² mbar. Bei diesen Drücken ist die mit der mittleren freien Weglänge korrelierte Energie der Plasmateilchen ausreichend gross, um an der Oberfläche des Werkstoffs oder des Bauteils zu chemischen Reaktionen zu führen, die bei niedrigen Temperaturen und Atmosphärendruck nicht möglich oder sehr unwahrscheinlich sind. Die Plasmaaktivierung wird üblicherweise bei einer Temperatur von 20 °C bis 100 °C, insbesondere 30 °C bis 60 °C, für eine Zeitdauer von 1 bis 30 Min., insbesondere 3 bis 10 Min., durchgeführt.

Vorzugsweise ist die Gasentladung eine DC- (Gleichstrom), AC-(Wechselstrom), HF-, RF- oder Mikrowellen-Gasentladung, wobei eine DC-Gasentladung besonders bevorzugt ist. Die DC-Leistung beträgt 500 bis 3000 W je Plasmaquelle, vorzugsweise 1500 bis 2500 W.

Als Gase für die Gasentladung werden Edelgase und gegebenenfalls Reaktivgase verwendet. Das Edelgas kann Ar, Ne, Kr und Xe sein, wobei Ar bevorzugt verwendet ist. Geeignete Reaktivgase umfassen Stickstoff, Kohlenstoff und/oder Sauerstoff enthaltende Gase, vorzugsweise Stickstoff (N₂), Kohlendioxid (CO₂), Ethan (C₂H₆), Ethylen (C₂H₄), Acetylen (C₂H₂) und O₂, sind jedoch nicht darauf beschränkt. Vorzugsweise ist das Gas lediglich Ar.

Die Erzeugung des Plasmas kann in einer wie im Deutschen Patent DE 36 15 361 C2 beschriebenen Plasmaquelle ausserhalb der Prozesskammer erfolgen. Dabei wird das Edelgas kontinuierlich in die Plasmaquelle eingeleitet, wo ein Plasma mittels einer Gasentladung erzeugt wird und dieses dann durch eine Öffnung in die Prozesskammer gelangt und auf die zu behandelnde Oberfläche des Werkstoffes oder Bauteils trifft. Das Reaktivgas, falls vorhanden, kann kontinuierlich in die Prozesskammer oder in die Plasmaquelle eingeleitet werden, wodurch das Reaktivgas ionisiert wird und das Edelgas/Reaktivgas-Plasma auf die Oberfläche des Werkstoffs oder Bauteils auftrifft.

Die Prozessparameter, wie die kinetische Energie der Teilchen, die verwendeten Gase, die Art der Gasentladung, die Einwirkdauer des Plasmas auf die Substratoberfläche und der Druck in der Prozesskammer werden genau kontrolliert, wodurch eine spezifisch modifizierte Oberfläche des erfindungsgemässen Werkstoffes oder Bauteils mit charakteristischen Eigenschaften erhalten wird. Ein auf diese Art und Weise hergestellter Werkstoff oder hergestelltes Bauteil weist beispielsweise eine signifikant höhere Oberflächenenergie, d.h. grösser als 35 mN/m bis über 55 mN/m, insbesondere grösser als 40 mN/m, auf. Die Oberflächenenergie kann durch bekannte Verfahren, wie beispielsweise Messen des Kontaktwinkels, Verlaufen von Testtinten etc., bestimmt werden.

Das beschriebende Plasmaverfahren ist im Gegensatz zu Verfahren, die auf Plasmaeinkopplungen beruhen, gut reproduzierbar und kontrollierbar, da die Oberfläche der Werkstoffe oder Bauteile gleichmässig mit Plasma aus der Plasmaquelle bestrahlt wird. Die mittels des Plasmaverfahrens der vorliegenden Erfindung aktivierten Oberflächen bleiben für einige Stunden bis über 5 Tage aktiv, bevor sie der nachfolgenden Direktmetallisierung unterzogen werden. Durch die oben beschriebenen Prozessparamter der Vorbehandlung und die Prozessparameter der Metallisierung, wie beispielsweise die kinetische Energie der Teilchen, das verwendete Prozessgas, die Dauer der Bestäubung, der Druck in der Prozesskammer etc., ist es möglich einen Werkstoff oder ein Bauteil, beispielsweise aus Polymer, wie Silikon oder TPU, direkt zu metallisieren, wodurch die heutzutage häufig als Haftvermittler eingesetzten Lacksysteme entfallen und Kosten eingespart werden. Die Aktivierung der Oberfläche und die nachfolgende Direktmetallisierung können überdies in derselben Vakuumanlage durchgeführt werden, wodurch das Verfahren vereinfacht und kostengünstiger wird.

Die erfindungsgemässen Werkstoffe oder Bauteile können für einer Vielzahl von Anwendungen verwendet werden, da sie die gewünschten Oberflächeneigenschaften, wie z.B. metallischer Glanz, mit einer angenehmen Haptik, insbesondere im Falle sogenannter Softoberflächen, vereinen. Beispiele für die Anwendungsgebiete solcher Werkstoffe oder Bauteile sind Maschinenkomponenten und -zubehör, Kraftfahrzeuge, wie Tasten von Kfz-Lenkrädern, Telekommunikationsgeräte, wie Mobiltelefon- und Computertastaturen, Haushaltsgeräte, Badarmaturen und -zubehör, Küchenarmaturen und -zubehör und Schmuck- und andere Gebrauchsgegenstände. Ein weiteres Einsatzgebiet stellt die Medizintechnik dar, wo beispielsweise metallisierte Bauteile aus flexiblem Silikon als leitfähige und dennoch flexible Sonden eingesetzt werden können.

## Patentansprüche

1. Werkstoff oder Bauteil mit einer Metallbeschichtung,
**dadurch gekennzeichnet, daß**
die Metallbeschichtung durch eine Direktmetallisierung auf die Oberfläche des Werkstoffs oder Bauteils aufgebracht ist und die Metallbeschichtung aus einer oder mehreren aufeinander liegenden gleichen oder unterschiedlichen Metallschichten besteht.

2. Werkstoff oder Bauteil mit einer Metallbeschichtung nach Anspruch 1,
**dadurch gekennzeichnet, daß**
die Metallbeschichtung teillichtdurchlässig ist und eine Gesamtschichtdicke von 20 bis 200 nm aufweist.

3. Werkstoff oder Bauteil mit einer Metallbeschichtung nach Anspruch 1,
**dadurch gekennzeichnet, daß**
die Metallbeschichtung nicht lichtdurchlässig ist und eine Gesamtschichtdicke von 100 bis 5000 nm aufweist.

4. Werkstoff oder Bauteil mit einer Metallbeschichtung nach einem der Ansprüche 1 bis 3,
**dadurch gekennzeichnet, daß**
eine einzelne Metallschicht der Metallbeschichtung eine Dicke von 3 bis 120 nm aufweist.

5. Werkstoff oder Bauteil mit einer Metallbeschichtung nach einem der Ansprüche 1 bis 4,
**dadurch gekennzeichnet, daß**
die eine oder mehreren aufeinander liegenden gleichen oder unterschiedlichen Metallschichten aus wenigstens einem Metall ausgewählt aus den Elementen der Gruppen 4 bis 14 des Periodensystems, Legierungen davon und/oder Edelstahl bestehen.

6. Werkstoff oder Bauteil mit einer Metallbeschichtung nach Anspruch 5,
**dadurch gekennzeichnet, daß**
das wenigstens eine Metall ausgewählt ist aus den Elementen der Gruppen 4 bis 6 des Periodensystems, Al, Rh und Si, Legierungen davon und/oder Edelstahl.

7. Werkstoff oder Bauteil mit einer Metallbeschichtung nach Anspruch 5 oder 6,
**dadurch gekennzeichnet, daß**
das wenigstens eine Metall ausgewählt ist aus den Elementen Ti, Zr, Cr, Mo, Rh, Al, Si, Legierungen davon und/oder Edelstahl.

8. Werkstoff oder Bauteil mit einer Metallbeschichtung nach einem der Ansprüche 5 bis 7,
**dadurch gekennzeichnet, daß**
eine oder mehrere der aufeinander liegenden gleichen oder unterschiedlichen Metallschichten metallkeramische Schichten sind.

9. Werkstoff oder Bauteil mit einer Metallbeschichtung nach einem der Ansprüche 1 bis 8,
**dadurch gekennzeichnet, daß**
der Gehalt eines bestimmten Elementes in den einen oder mehreren aufeinander liegenden gleichen oder unterschiedlichen Metallschichten von der auf der Oberfläche des Werkstoffs oder Bauteils aufliegenden ersten Metallschicht bis zur letzten Metallschicht variiert.

10. Werkstoff oder Bauteil mit einer Metallbeschichtung nach einem der Ansprüche 1 bis 9,
**dadurch gekennzeichnet, daß**
der Werkstoff oder das Bauteil aus einem Material ausgewählt aus der Gruppe umfassend metallische Materialien, Glas, Keramik, Polymere, Holz und Gummi besteht.

11. Werkstoff oder Bauteil mit einer Metallbeschichtung nach Anspruch 10,
**dadurch gekennzeichnet, daß**
der Werkstoff oder das Bauteil aus einem Polymer besteht.

12. Werkstoff oder Bauteil mit einer Metallbeschichtung nach Anspruch 11,
**dadurch gekennzeichnet, daß**
das Polymer ein flexibles thermoplastisches Elastomer ist.

13. Werkstoff oder Bauteil mit einer Metallbeschichtung nach einem der Ansprüche 1 bis 12,
**dadurch gekennzeichnet, daß**
die Direktmetallisierung der Oberfläche des Werkstoffs oder Bauteiles mittels eines PVD-Verfahrens erfolgt.

14. Werkstoff oder Bauteil mit einer Metallbeschichtung nach Anspruch 13,
**dadurch gekennzeichnet, daß**
das PVD-Verfahren mittels Sputtern erfolgt.

15. Werkstoff oder Bauteil mit einer Metallbeschichtung nach einem der Ansprüche 1 bis 14,
**dadurch gekennzeichnet, daß**
die Oberfläche des Werkstoffs oder Bauteils vor der Direktmetallisierung gegebenenfalls aktiviert wird.

16. Werkstoff oder Bauteil mit einer Metallbeschichtung nach Anspruch 15,
**dadurch gekennzeichnet, daß**
die Aktivierung durch ein Plasmaverfahren erfolgt.

17. Werkstoff oder Bauteil mit einer Metallbeschichtung nach Anspruch 16,
**dadurch gekennzeichnet, daß**
das Plasmaverfahren zur Aktivierung die Schritte des Einbringens des Werkstoffes oder Bauteils in eine Prozesskammer, des Ausgasens desselben, des kontinuierlichen Abpumpens der Ausgasungen mittels Vakuumpumpen und des Aktivierens der Oberfläche des Werkstoffs oder Bauteils mit einem durch eine elektrische Gasentladung im Vakuum erzeugten Plasma umfasst, wobei die Energie und die Einwirkdauer des Plasmas auf die Oberfläche des Werkstoffs oder Bauteils so gewählt sind, dass die oberflächennahen Moleküle signifikant modifiziert werden und der Werkstoff oder das Bauteil direkt mit einem PVD-Verfahren metallisiert werden kann.

18. Werkstoff oder Bauteil mit einer Metallbeschichtung nach Anspruch 17,
**dadurch gekennzeichnet, daß**
der Schritt des Ausgasens des Werkstoffs oder Bauteils bei einem Druck von 10⁻⁵ bis 10⁻¹ mbar erfolgt.

19. Werkstoff oder Bauteil mit einer Metallbeschichtung nach Anspruch 17 oder 18,
**dadurch gekennzeichnet, daß**
das Aktivieren der Oberfläche des Werkstoffs oder Bauteils bei einem Druck von 10⁻⁴ bis 10⁻¹ mbar erfolgt.

20. Werkstoff oder Bauteil mit einer Metallbeschichtung nach einem der Ansprüche 17 bis 19,
**dadurch gekennzeichnet, daß**
die Gasentladung eine DC-, AC-, HF-, RF- oder Mikrowellen-Gasentladung ist.

21. Werkstoff oder Bauteil mit einer Metallbeschichtung nach einem der Ansprüche 17 bis 20,
**dadurch gekennzeichnet, daß**
die Gasentladung in Gegenwart eines Edelgases ausgewählt aus Ar, Ne, Kr, Xe und gegebenenfalls eines Reaktivgases, umfassend ein Stickstoff, Kohlenstoff und/oder Sauerstoff enthaltendes Gas, erfolgt.

22. Werkstoff oder Bauteil mit einer Metallbeschichtung nach einem der Ansprüche 17 bis 21,
**dadurch gekennzeichnet, daß**
die Gasentladung in einer Plasmaquelle erfolgt, das Edelgas und das Reaktivgas, falls vorhanden, kontinuierlich der Plasmaquelle zugeführt werden und die Gase kontinuierlich mittels Vakuumpumpen aus der Prozesskammer abgepumpt werden.

23. Werkstoff oder Bauteil mit einer Metallbeschichtung nach einem der Ansprüche 17 bis 22,
**dadurch gekennzeichnet, daß**
die Gasentladung in einer Plasmaquelle erfolgt, das Edelgas kontinuierlich in die Plasmaquelle eingeleitet wird, das Reaktivgas, falls vorhanden, direkt der Prozesskammer zugeführt wird und die Gase kontinuierlich mittels Vakuumpumpen aus der Prozesskammer abgepumpt werden.

24. Werkstoff oder Bauteil mit einer Metallbeschichtung nach einem der Ansprüche 1 bis 23,
**dadurch gekennzeichnet, daß**
der Werkstoff oder das Bauteil auf der letzten Metallschicht zusätzlich eine Deckschicht aufweist.

25. Werkstoff oder Bauteil mit einer Metallbeschichtung nach Anspruch 24,
**dadurch gekennzeichnet, daß**
die Deckschicht eine Lackschicht oder eine Plasmapolymerschicht ist.

26. Werkstoff oder Bauteil aus Silikon oder thermoplastischem Polyurethan mit einer Metallbeschichtung,
**dadurch gekennzeichnet, daß**
die Metallbeschichtung durch eine Direktmetallisierung auf die Silikon- oder thermoplastische Polyurethan-Oberfläche des Werkstoffs oder Bauteils aufgebracht ist und die Metallbeschichtung aus einer oder mehreren aufeinander liegenden gleichen oder unterschiedlichen Metallschichten besteht.

27. Werkstoff oder Bauteil aus Silikon oder thermoplastischem Polyurethan mit einer Metallbeschichtung nach Anspruch 26,
**dadurch gekennzeichnet, daß**
der Werkstoff oder das Bauteil aus flexiblem Silikon besteht.

28. Werkstoff oder Bauteil aus Silikon oder thermoplastischem Polyurethan mit einer Metallbeschichtung nach Anspruch 27,
**dadurch gekennzeichnet, daß**
das flexible Silikon Dimethylsiloxan ist.

29. Werkstoff oder Bauteil aus Silikon oder thermoplastischem Polyurethan mit einer Metallbeschichtung nach Anspruch 26,
**dadurch gekennzeichnet, daß**
der Werkstoff oder das Bauteil aus flexiblem thermoplastischem Polyurethan besteht.

30. Werkstoff oder Bauteil aus Silikon oder thermoplastischem Polyurethan mit einer Metallbeschichtung nach einem der Ansprüche 26 bis 29,
**dadurch gekennzeichnet, daß**
die eine oder mehreren aufeinander liegenden gleichen oder unterschiedlichen Metallschichten aus wenigstens einem Metall ausgewählt aus den Elementen der Gruppen 4 bis 6 und Al, Legierungen davon und/oder Edelstahl bestehen.

31. Werkstoff oder Bauteil aus Silikon oder thermoplastischem Polyurethan mit einer Metallbeschichtung nach Anspruch 30,
**dadurch gekennzeichnet, daß**
das wenigstens eine Metall aus der Gruppe bestehend aus Ti, Zr, Cr und Al ausgewählt ist.

32. Werkstoff oder Bauteil aus Silikon oder thermoplastischem Polyurethan mit einer Metallbeschichtung nach einem der Ansprüche 26 bis 31,
**dadurch gekennzeichnet, daß**
die Metallbeschichtung eine Dicke von 50 nm bis 1200 nm aufweist.

33. Werkstoff oder Bauteil aus Silikon oder thermoplastischem Polyurethan mit einer Metallbeschichtung nach einem der Ansprüche 26 bis 32,
**dadurch gekennzeichnet, daß**
die Direktmetallisierung der Silikon- oder thermoplastische Polyurethan-Oberfläche des Werkstoffes oder Bauteils mittels eines PVD-Verfahrens erfolgt.

34. Werkstoff oder Bauteil aus Silikon oder thermoplastischem Polyurethan mit einer Metallbeschichtung nach Anspruch 33,
**dadurch gekennzeichnet, daß**
das PVD-Verfahren durch Sputtern erfolgt.

35. Werkstoff oder Bauteil aus Silikon oder thermoplastischem Polyurethan mit einer Metallbeschichtung nach Anspruch 26 bis 34,
**dadurch gekennzeichnet, daß**
die Silikon- oder thermoplastische Polyurethan-Oberfläche des Werkstoffs oder Bauteils vor der Direktmetallisierung mittels eines Plasmaverfahrens aktiviert ist.

36. Werkstoff oder Bauteil aus Silikon oder thermoplastischem Polyurethan mit einer Metallbeschichtung nach Anspruch 35,
**dadurch gekennzeichnet, daß**
die Aktivierung nach dem in den Ansprüchen 17 bis 23 beschriebenen Plasmaverfahren erfolgt.

37. Werkstoff oder Bauteil aus Silikon oder thermoplastischem Polyurethan mit einer Metallbeschichtung nach einem der Ansprüche 26 bis 36,
**dadurch gekennzeichnet, daß**
der Werkstoff oder das Bauteil auf der letzten Metallschicht zusätzlich eine Deckschicht aufweist.

38. Werkstoff oder Bauteil aus Silikon oder thermoplastischem Polyurethan mit einer Metallbeschichtung nach Anspruch 37,
**dadurch gekennzeichnet, daß**
die Deckschicht eine Lackschicht oder eine Plasmapolymerschicht ist.

39. Verwendung eines Bauteils nach einem der Ansprüche 1 bis 38 für Kraftfahrzeuge, Telekommunikationsgeräte, Haushaltsgeräte, Badarmaturen und - zubehör, Küchenarmaturen und -zubehör, medizinische Geräte, Schmuck- und Gebrauchsgegenstände.
